(19) Europäisches Patentamt
European Patent Office
Office européen des brevets

(11) **EP 2 479 799 A1**

(12) **EUROPEAN PATENT APPLICATION**
published in accordance with Art. 153(4) EPC

(43) Date of publication:
**25.07.2012   Bulletin 2012/30**

(51) Int Cl.:
**H01L 31/042** (2006.01)

(21) Application number: **10816941.8**

(22) Date of filing: **01.06.2010**

(86) International application number:
**PCT/JP2010/059235**

(87) International publication number:
**WO 2011/033828 (24.03.2011 Gazette 2011/12)**

(84) Designated Contracting States:
**AL AT BE BG CH CY CZ DE DK EE ES FI FR GB
GR HR HU IE IS IT LI LT LU LV MC MK MT NL NO
PL PT RO SE SI SK SM TR**

(30) Priority: **17.09.2009   JP 2009215822**

(71) Applicant: **Fuji Electric Co., Ltd.**
**Kawasaki-shi
Kanagawa
210-9530 (JP)**

(72) Inventors:
• **NAMIKI, Yoichi**
**Kawasaki-shi
Kanagawa 210-0856 (JP)**

• **HITOMI, Miyako**
**Kawasaki-shi
Kanagawa 210-0856 (JP)**
• **TANDA, Masayuki**
**Kawasaki-shi
Kanagawa 210-0856 (JP)**

(74) Representative: **Appelt, Christian W.**
**Boehmert & Boehmert
Pettenkoferstrasse 20-22
80336 München (DE)**

(54) **SOLAR CELL MODULE LAMINATE**

(57)    A solar cell module laminated body including a solar cell module and a supporting body, such as a metal plate, resin sheet, or tile, that supports the solar cell module, the solar cell module being bonded to the supporting body using an adhesive layer, has a structure wherein a minimum necessary adhesive area is calculated based on the ratio of a minimum adhesive strength required of the solar cell module laminated body and an adhesive strength of the solar cell module and adhesive layer, and an amount of adhesive used is kept to a minimum. According to this structure, cost is reduced in accordance with the amount of adhesive used. Consequently, it is possible to balance a reduction in the cost of the solar cell module laminated body and sufficient adhesive strength.

Fig. 1

**EP 2 479 799 A1**

**Description**

Technical Field

The present invention relates to a solar cell module laminated body including a solar cell module and a supporting body, such as a metal plate, resin sheet, or tile, that supports the solar cell module, and relates to a solar cell module laminated body wherein the solar cell module is bonded to the supporting body using an adhesive layer.

Background Art

In order to obtain power by installing a solar cell module outdoors, it is necessary to fix the solar cell module to a structure such as a building or mounting. To this end, there are methods of attaching the solar cell module to a supporting body such as a metal plate, resin sheet, or tile, which is one portion of the structure.

As one specific attachment method, there is a configuration wherein the supporting body and solar cell module are stacked using an adhesive layer. For example, in Patent Document 1 below, there is disclosed a laminated body wherein a solar cell panel and at least thermal insulating material and a flat plate, provided on the rear surface side of the solar cell panel, are integrated using an adhesive layer. Also, in Patent Document 2, there is disclosed a configuration wherein a metal roof and a solar cell panel are bonded using double-sided tape.

Prior Art Documents

Patent Documents

    Patent Document 1: JP-A-9-119202
    Patent Document 2: JP-A-6-85306

Summary of the Invention

Problems that the Invention is to Solve

The solar cell module laminated bodies wherein the whole areas of the supporting body and solar cell module are bonded, described in the related art documents, have the following problems.

Firstly, as a cost in accordance with an amount used of the adhesive layer used in the bonding is added to the cost of the solar cell module laminated body, when the adhesive layer is used over the whole of a non-light receiving surface of the solar cell module, there is a drawback in that, although the adhesive strength of the supporting body and solar cell module is sufficient, the cost of the solar cell module laminated body increases.

Meanwhile, when the amount used of the adhesive layer used in the bonding is reduced, there is an advantage in that the cost of the solar cell module laminated body decreases, but there is a danger that the adhesive strength of the supporting body and solar cell module is insufficient.

The invention, having been contrived in order to solve these kinds of problem, has an object of providing a solar cell module laminated body with a structure wherein it is possible to balance a reduction in the cost of the solar cell module laminated body and sufficient adhesive strength of a supporting body and solar cell module.

Means for Solving the Problems

In order to achieve the object, the invention is a solar cell module laminated body including a solar cell module and a supporting body formed by a metal plate, resin sheet, tile, or the like, that supports the solar cell module, the solar cell module being bonded to the supporting body using an adhesive layer, wherein an adhesive area proportional to adhesive strength is determined based on the strength ratio of a shear adhesive strength required of the solar cell module laminated body and a tensile shear adhesive strength when assuming that the whole area of the solar cell module is bonded. As a result of this, a structure is such that the minimal amount of adhesive layer necessary in order to obtain the solar cell module laminated body is disposed.

Advantage of the Invention

According to the invention, the cost decreases in accordance with the amount of adhesive layer, and it is possible to obtain a solar cell module laminated body with a structure wherein it is possible to balance a reduction in the cost of the solar cell module laminated body and sufficient adhesive strength between a supporting body and solar cell module.

Brief Description of the Drawings

[Fig. 1] Fig. 1 is a sectional view of a solar cell module laminated body according to an embodiment of the invention.
[Fig. 2] Fig. 2 is a sectional view along A-A of Fig. 1 when an adhesive layer is formed from an assembly of band-like portions.
[Fig. 3] Fig. 3 is a sectional view along A-A of Fig. 1 when the adhesive layer is formed from an assembly of circular portions.

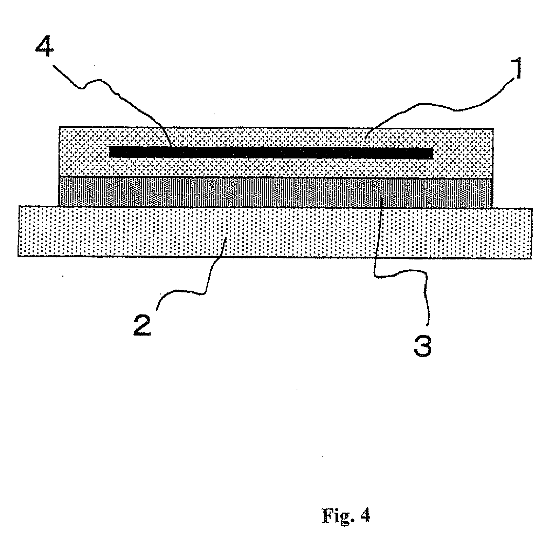

[Fig. 4] Fig. 4 is a sectional view of a heretofore known solar cell module laminated body.

Mode for Carrying Out the Invention

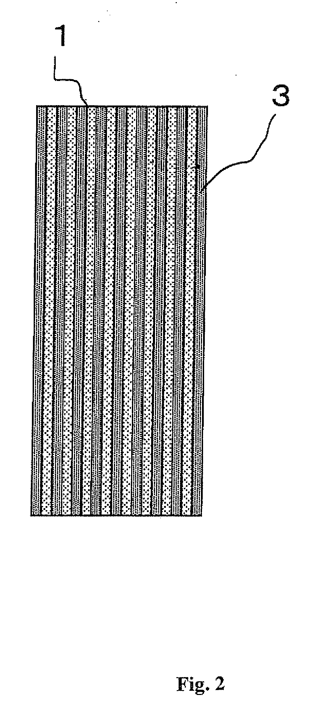

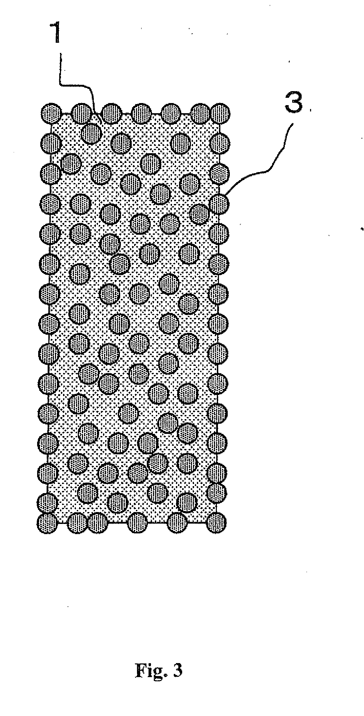

Hereafter, a description will be given, referring to the drawings, of an embodiment of the invention.

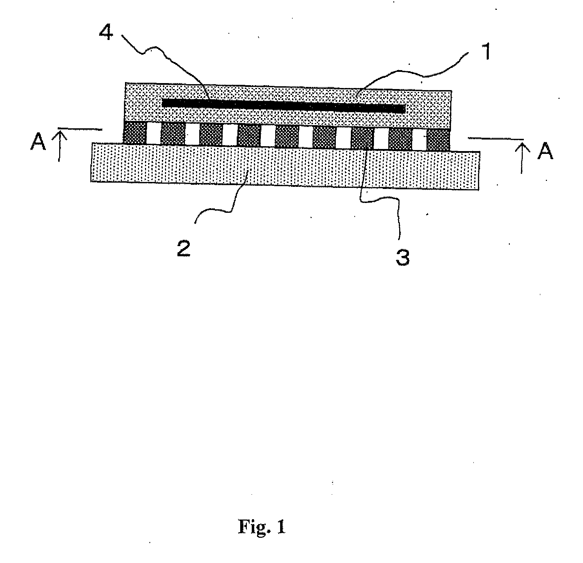

Fig. 1 is a sectional view showing the structure of a solar cell module laminated body according to the embodiment of the invention. In Fig. 1, the solar cell module laminated body is configured by a solar cell module 1 being supported by a supporting body 2 across an adhesive layer 3. A solar cell element 4 is enveloped by the solar cell module 1.
Herein, the adhesive layer 3 occupies one portion between the solar cell module 1 and supporting body 2. The portion between the solar cell module 1 and supporting body 2 not occupied by the adhesive layer 3 is an empty space, but a material other than the adhesive layer, for example, a drying agent or a heat transfer agent, may be packed into one portion or the whole of the empty space.
Although the form of the adhesive layer 3 interposed between the solar cell module 1 and supporting body 2 is not particularly limited, a band form and circular form are suggested as preferable examples. Of these, a plane sectional view when the adhesive layer is an assembly of band-like portions is shown in Fig. 2. Also, a plane sectional view when the adhesive layer is an assembly of circular portions is shown in Fig. 3.
When the adhesive layer is disposed continuously or intermittently in a portion of a length at least one half of the overall length of the external edge portion of the solar cell module, an advantage of preventing detachment of the solar cell module 1 from the supporting body 2 is particularly high.
A polymeric material such as polyethylene, an ethylene-vinyl acetate copolymer, a fluorine series resin, or a polyester resin, or a metal, can be used as the material of an adhesive surface side of the solar cell module 1. A metal plate, a resin sheet, a tile, or the like, can be used for the supporting body 2. These may be such that the surface is covered with a material other than the main material thereof.
When both the solar cell module 1 and supporting body 2 are flexible, the solar cell module laminated body obtained in the invention is also flexible, meaning that there is an advantage in that there is an increase in ways of using the solar cell module laminated body, such as installing it on a curved surface portion of an external wall of a building or transporting it rolled up.
It is possible to carry out a surface treatment using a corona discharge, plasma, or the like, or apply a primer coating, on the surfaces of both the solar cell module 1 and supporting body 2 in order to increase adhesion to the adhesive layer 3.
In order to absorb a discrepancy in dimensional change resulting from a difference in the thermal expansion rates of the solar cell module 1 and supporting body 2, distortion occurring when deforming the flexible solar cell module laminated body, and the like, thus preventing damage to the adhesive interface, it is preferable that the elasticity of the adhesive layer 3 is 100 MPa or less, and in order to maintain adhesive strength, thus preventing unnecessary distortion of the solar cell module laminated body, it is preferable that the elasticity of the adhesive layer 3 is 100 kPa or more.
A reaction curing type adhesive or a pressure sensitive adhesive sheet can be used for the adhesive layer 3. Although it is possible to use a silicone series adhesive, an acrylic adhesive, an epoxy series adhesive, or the like, as a reaction curing type adhesive, a silicone series adhesive is particularly suitable. It is possible to use a moisture curing type, a thermal curing type, a light curing type, or a two-liquid mixed curing type of adhesive as a silicone series adhesive. It is possible to use one of a butyl rubber series, acrylic foam series, or the like, as a pressure sensitive adhesive sheet, and it may also contain a film, a mesh, or the like, with an object of increasing strength, or the like.
Next, a specific description will be given of main points of the invention.
An adhesive area of the adhesive layer 3 disposed between the solar cell module 1 and supporting body 2 is calculated using the following Equation (1).

$$Aa = Am \times Sd/Sm \cdots (1)$$

Herein, Aa is the minimum adhesive area necessary for the adhesive layer 3, Am is the area of the solar cell module 1, Sd is the value of the minimum shear strength of the solar cell module 1 and supporting body 2 required of the solar cell module laminated body, and Sm is the value of the shear adhesive strength exerted over the whole of the solar cell module 1 and supporting body 2 when supposing an adhesion over the whole surface of the solar cell module 1 using the adhesive layer 3.

The tensile shear adhesive strength of the solar cell module 1 and supporting body 2 of the solar cell module laminated body obtained by adhesion with the adhesive layer 3 having the adhesive area Aa calculated using Equation (1) is the tensile shear adhesive strength Sd. Also, in the case of this adhesive area, the amount of the adhesive layer is minimal, and the solar cell module laminated body cost reducing effect is high.

When there is little need to reduce the cost of the solar cell module laminated body, the adhesive area of the adhesive layer 3 may be larger than the previously mentioned Aa calculated using Equation (1). When using an adhesive layer 3 with an adhesive area larger than the previously mentioned Aa, it is possible to obtain a solar cell module laminated body with a tensile shear adhesive strength greater than the previously mentioned Sd.

By adopting the heretofore described kind of solar cell module laminated body structure, it is possible to obtain a solar cell module laminated body with which it is possible to balance cost reduction and sufficient adhesive strength.

Examples

Next, the invention will be further described giving Examples and Comparative Examples. Results of Example 1 and Comparative Examples are shown in Table 1, results of Example 2 and Comparative Examples in Table 2, and results of Example 3 and Comparative Examples in Table 3.

(Example 1)

A flexible type with a thickness of 0.85 mm is used for the solar cell module. The material of the adhesive surface side is an ethylene tetrafluoroethylene copolymer, and the surface of the adhesive surface side is plasma treated. A polyvinylidene fluoride-chlorine trifluoride vinyl copolymer sheet with a thickness of 0.58 mm is used for the supporting body. A tape-form acrylic foam series pressure sensitive adhesive sheet with a thickness of 0.4 mm and width of 12.5 mm is used for the adhesive.

The solar cell module in Example 1 has a length of 500 mm and a width of 250 mm, meaning that the area Am of the solar cell module used in Equation (1) is 125,000 $mm^2$.

The shear adhesive strength Sd required of the solar cell module laminated body in Example 1, being a value set based on the installation environment and the like, is 3.0 $N/cm^2$.

The shear adhesive strength Sm of the tape-form acrylic foam series pressure sensitive adhesive sheet in Example 1 is calculated by bonding the solar cell module and supporting body over an adhesive area of 1 $cm^2$ using the tape-form acrylic foam series pressure sensitive adhesive sheet and conducting a shear adhesive strength test, the result of which is 24. 0 $N/cm^2$. Also, the price of the tape-form acrylic foam series pressure sensitive adhesive sheet is 0.4 yen per 1 $cm^2$.

Using Equation (1), the necessary adhesive area Aa is calculated to be 15,625 $mm^2$. Therefore, a solar cell module laminated body is obtained by making the adhesive area 18,750 $mm^2$ using three of the tape-form acrylic foam series pressure sensitive adhesive sheets with a length of 500 mm, and bonding the solar cell module and supporting body in the way shown in Fig. 2.

The price of the tape-form acrylic foam series pressure sensitive adhesive sheet used is calculated from the unit price thereof and the adhesive area to be 75 yen. Also, the result of measuring the shear adhesive strength of the solar cell module laminated body obtained is 3.5 $N/cm^2$, exceeding the required value of 3.0 $N/cm^2$.

(Comparative Example 1)

The amount of tape-form acrylic foam series pressure sensitive adhesive sheet used is changed with respect to the conditions of Example 1. A solar cell module laminated body is obtained by making the adhesive area 12,500 $mm^2$ using two tape-form acrylic foam series pressure sensitive adhesive sheets with a length of 500 mm, and bonding in the same way as that shown in Fig. 2.

The price of the tape-form acrylic foam series pressure sensitive adhesive sheet used is calculated from the unit price thereof and the adhesive area to be 50 yen, lower than the 75 yen of Example 1. However, as the result of measuring the shear adhesive strength of the solar cell module laminated body obtained is 2.3 $N/cm^2$, lower than the

required value of 3.0 N/cm$^2$, it is clear that it does not stand up to use.

(Comparative Example 2)

The amount of tape-form acrylic foam series pressure sensitive adhesive sheet used is changed with respect to the conditions of Example 1. A solar cell module laminated body is obtained by making the adhesive area 125, 000 mm$^2$ using twenty tape-form acrylic foam series pressure sensitive adhesive sheets with a length of 500 mm, and bonding over the whole surface of the solar cell module.

The result of measuring the shear adhesive strength of the solar cell module laminated body obtained is 23.1 N/cm$^2$, exceeding the required value of 3.0 N/cm$^2$. However, the price of the tape-form acrylic foam series pressure sensitive adhesive sheet used is calculated from the unit price thereof and the adhesive area to be 500 yen, exceeding the 75 yen of Example 1.

(Table 1)

|  | Shear Adhesive Strength (N/cm$^2$) | Price of Adhesive Layer Used (Yen) |
|---|---|---|
| Example 1 | 3.5 | 75 |
| Comparative Example 1 | 2.3 | 50 |
| Comparative Example 2 | 23.1 | 500 |

(Example 2)

The same solar cell module and supporting body as in Example 1 are used. A moisture curing type silicone series adhesive is used for the adhesive layer, and the coating thickness is 0.5 mm. The shear adhesive strength Sd required of the solar cell module laminated body in Example 2, being a value set based on the installation environment and the like, is 2.0 N/cm$^2$.

The shear adhesive strength Sm of the moisture curing type silicone series adhesive in Example 2 is calculated by bonding the solar cell module and supporting body over an adhesive area of 1 cm$^2$ using the moisture curing type silicone series adhesive and conducting a shear adhesive strength test, the result of which is 22.4 N/cm$^2$. Also, the price when applying the moisture curing type silicone series adhesive to a thickness of 0.5 mm is 0.45 yen per 1 cm$^2$.

Using Equation (1), the necessary adhesive area Aa is calculated to be 11,161 mm$^2$. Therefore, a solar cell module laminated body is obtained by making the adhesive area 12, 000 mm$^2$, and bonding the solar cell module and supporting body in the way shown in Fig. 3.

The price of the moisture curing type silicone series adhesive used is calculated from the unit price thereof and the adhesive area to be 54 yen. Also, the result of measuring the shear adhesive strength of the solar cell module laminated body obtained is 2.1 N/cm$^2$, exceeding the required value of 2.0 N/cm$^2$.

(Comparative Example 3)

The amount of moisture curing type silicone series adhesive used is changed with respect to the conditions of Example 2, and a solar cell module laminated body is obtained by making the adhesive area 10, 000 cm$^2$, and bonding in the same way as that shown in Fig. 3.

The price of the moisture curing type silicone series adhesive used is calculated from the unit price thereof and the adhesive area to be 45 yen, lower than the 54 yen of Example 2. However, as the result of measuring the shear adhesive strength of the solar cell module laminated body obtained is 1.7 N/cm$^2$, lower than the required value of 2.0 N/cm$^2$, it is clear that it does not stand up to use.

(Comparative Example 4)

The amount of moisture curing type silicone series adhesive used is changed with respect to the conditions of Example 2, and a solar cell module laminated body is obtained by making the adhesive area 125,000 mm$^2$, and bonding over the whole surface of the solar cell module.

The result of measuring the shear adhesive strength of the solar cell module laminated body obtained is 21.7 N/cm$^2$, exceeding the required value of 2.0 N/cm$^2$. However, the price of the moisture curing type silicone series adhesive used is calculated from the unit price thereof and the adhesive area to be 563 yen, exceeding the 54 yen of Example 2.

(Table 2)

| | Shear Adhesive Strength (N/cm$^2$) | Price of Adhesive Used (Yen) |
| --- | --- | --- |
| Example 2 | 2.1 | 54 |
| Comparative Example 3 | 1.7 | 45 |
| Comparative Example 4 | 21.7 | 563 |

(Example 3)

A flexible type solar cell module with dimensions of length 500 mm, width 250 mm, thickness 0.85 mm, and area Am 125, 000 mm$^2$ is used. The material of the adhesive surface side is an ethylene tetrafluoroethylene copolymer, and the surface of the adhesive surface side is plasma treated. A polyvinylidene fluoride-chlorine trifluoride vinyl copolymer sheet with a thickness of 0.58 mm is used for the supporting body. A tape-form acrylic foam series pressure sensitive adhesive sheet with a thickness of 0.4 mm and width of 12.5 mm is used for the adhesive.

The shear adhesive strength Sd required of the solar cell module laminated body in Example 3, being a value set based on the installation environment and the like, is 3.0 N/cm$^2$.

The tensile shear adhesive strength Sm of the tape-form acrylic foam series pressure sensitive adhesive sheet in Example 3 is calculated by bonding the solar cell module and supporting body over an adhesive area of 1 cm$^2$ using the tape-form acrylic foam series pressure sensitive adhesive sheet and conducting a shear adhesive strength test, the result of which is 24.0 N/cm$^2$.

Using Equation (1), the necessary minimum adhesive area Aa is calculated to be 15, 625 mm$^2$. Therefore, the adhesive area is made 18,750 mm$^2$ using the tape-form acrylic foam series pressure sensitive adhesive sheet, and four kinds of solar cell module laminated body are fabricated by changing the length of the adhesive layer 3 disposed on the external edge portion of the solar cell module, and bonding the supporting body and solar cell module. The individual ratios of the length of the external edge portion on which the adhesive layer 3 is disposed with respect to the overall length of the external edge portion of the solar cell module are 30, 50, 80, and 100%. Of these, the case in which the ratio of the length of the bonded external edge portion is 100% indicates that the adhesive layer 3 is disposed over the whole of the external edge portion.

Next, using the heretofore described four laminated bodies, a weather resistance test is conducted with a weatherometer. The bonding condition of the laminated bodies is visually examined after conducting a 500 hour test under conditions of an irradiance of 78 W/m$^2$, a temperature of 63°C, and a water spraying for 18 minutes every 120 minutes. The results thereof are shown in Table 3.

When disposing the adhesive layer on 50% or more of the overall length of the external edge portion of the solar cell module, there is no detachment of the module. However, in the laminated body in which only 30% of the overall length of the external edge portion of the solar cell module is bonded, a detachment of 1 cm of the solar cell module and supporting body is observed in the adhesive layer. These results indicate that disposing the adhesive layer 3 in a portion of a length one half the overall length of the external edge portion of the solar cell module has an advantage of preventing detachment of the solar cell module and supporting body.

(Table 3)

| Ratio of Length of External Edge Portion on which Adhesive Layer is Disposed | Result Observed After Weather Resistance Test |
| --- | --- |
| 30% | Detachment |
| 50% | No detachment |
| 80% | No detachment |
| 100% | No detachment |

(Example 4)

A module of length 500 mm, width 250m m, thickness 0.85 mm, and area Am 125,000 mm$^2$ is used as a flexible type solar cell module. The material of the adhesive surface side is an ethylene tetrafluoroethylene copolymer, and the surface of the adhesive surface side is plasma treated. A polyvinylidene fluoride-chlorine trifluoride vinyl copolymer sheet with a thickness of 0.58 mm is used for the supporting body. A tape-form acrylic foam series pressure sensitive adhesive sheet with a thickness of 0.4 mm and width of 12.5 mm is used for the adhesive layer.

The shear adhesive strength Sd required of the solar cell module laminated body in Example 4, being a value set based on the installation environment and the like, is 3.0 N/cm$^2$.

The shear adhesive strength Sm of the tape-form acrylic foam series pressure sensitive adhesive sheet in Example 4 is calculated by bonding the solar cell module and supporting body over an adhesive area of 1 cm$^2$ using the tape-form acrylic foam series pressure sensitive adhesive sheet and conducting a shear adhesive strength test, the result of which is 24. 0 N/cm$^2$. Also, the elasticity of the tape-form acrylic foam series pressure sensitive adhesive sheet in Example 4 is 500 kPa.

Using Equation (1), the necessary adhesive area Aa is calculated to be 15,625 mm$^2$. A solar cell module laminated body is obtained by making the adhesive area 18,750 mm$^2$ using a tape-form acrylic foam series pressure sensitive adhesive sheet with a length of 500 mm, and bonding the solar cell module and supporting body.

The solar cell module laminated body is installed vertically by the supporting body portion of the solar cell module laminated body being fixed to a building. When examining one year later, there is no deformation of the bonded portion of the solar cell module laminated body.

(Comparative Example 5)

The same flexible type solar cell module and supporting body as in Example 4 are used. A tape-form acrylic foam series pressure sensitive adhesive sheet with a thickness of 0.4 mm and width of 12.5 mm, and elasticity differing from that in Example 4, is used for the adhesive.

The elasticity of the tape-form acrylic foam series pressure sensitive adhesive sheet in Example 5 is 80 kPa. The shear adhesive strength Sd required of the solar cell module laminated body in Example 5 is 3. 0 N/cm$^2$, the same as in Example 4.

The shear adhesive strength Sm of the tape-form acrylic foam series pressure sensitive adhesive sheet in Example 5 is calculated by bonding the solar cell module and supporting body over an adhesive area of 1 cm$^2$ using the tape-form acrylic foam series pressure sensitive adhesive sheet and conducting a tensile shear adhesive strength test, the result of which is 24.5 N/cm$^2$, equivalent to that in Example 4.

A solar cell module laminated body is obtained by making the adhesive area the same 18,750 mm$^2$ as in Example 4, and bonding the solar cell module and supporting body.

The solar cell module laminated body is installed vertically by the supporting body portion of the solar cell module laminated body being fixed to a building. When examining one year later, the position of bonding of the solar cell module to the supporting body has slipped to approximately 1 cm below the initial position.

(Comparative Example 6)

The same flexible type solar cell module and supporting body as in Example 4 are used. A tape-form acrylic foam series pressure sensitive adhesive sheet with a thickness of 0.4 mm and width of 12.5 mm, and elasticity differing from that in Example 4 and Comparative Example 5, is used for the adhesive.

The elasticity of the tape-form acrylic foam series pressure sensitive adhesive sheet in Comparative Example 6 is 110 MPa. The tensile shear adhesive strength Sd required of the solar cell module laminated body in Comparative Example 6 is 3.0 N/cm$^2$, the same as in Example 4.

The tensile shear adhesive strength Sm of the tape-form acrylic foam series pressure sensitive adhesive sheet in Comparative Example 6 is calculated by bonding the solar cell module and supporting body over an adhesive area of 1 cm$^2$ using the tape-form acrylic foam series pressure sensitive adhesive sheet and conducting a tensile shear adhesive strength test, the result of which is 24.7 N/cm$^2$, equivalent to that in Example 4.

A solar cell module laminated body is obtained by making the adhesive area the same 18,750 mm$^2$ as in Example 4, and bonding the solar cell module and supporting body.

The solar cell module laminated body is installed vertically by the supporting body portion of the solar cell module laminated body being fixed to a building. When examining one year later, detachment is observed between the solar cell module and supporting body.

Description of Reference Numerals and Signs

1    Solar cell module

2    Supporting body

3    Adhesive layer

4    Solar cell element

**Claims**

**1.** A solar cell module laminated body, **characterized by** including:

a flexible type solar cell module; and
a supporting body that supports the solar cell module,
the solar cell module being bonded to the supporting body using an adhesive layer, wherein
the adhesive layer has an elasticity of 100 kPa or more, 100 MPa or less, and an adhesive area Aa thereof is
determined, based on an area Am of the solar cell module, a value Sd of a shear adhesive strength required
of a laminated body of the supporting body and solar cell module, and a value Sm of a shear adhesive strength
of the adhesive layer and solar cell module, using the following equation

$$Aa = Am \times Sd/Sm.$$

**2.** The solar cell module laminated body according to claim 1, **characterized in that**
the adhesive layer is disposed continuously or intermittently to a length at least one half of the overall length of the
external edge portion of the solar cell module.

**3.** The solar cell module laminated body according to claim 1 or claim 2, **characterized in that**
the adhesive layer is formed from a pressure sensitive adhesive.

**4.** The solar cell module laminated body according to claim 1 or claim 2, **characterized in that**
the adhesive layer is formed from a reaction curing type adhesive.

4   1

A   A

2   3

Fig. 1

Fig. 2

Fig. 3

Fig. 4

<table>
<tr><td colspan="2">**INTERNATIONAL SEARCH REPORT**</td><td>International application No.<br>PCT/JP2010/059235</td></tr>
</table>

A. CLASSIFICATION OF SUBJECT MATTER
*H01L31/042*(2006.01)i

According to International Patent Classification (IPC) or to both national classification and IPC

B. FIELDS SEARCHED

Minimum documentation searched (classification system followed by classification symbols)
H01L31/042

Documentation searched other than minimum documentation to the extent that such documents are included in the fields searched

| Jitsuyo Shinan Koho | 1922-1996 | Jitsuyo Shinan Toroku Koho | 1996-2010 |
| Kokai Jitsuyo Shinan Koho | 1971-2010 | Toroku Jitsuyo Shinan Koho | 1994-2010 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| X | JP 06-085303 A (Canon Inc.),<br>25 March 1994 (25.03.1994),<br>paragraphs [0014], [0022], [0024], [0026],<br>[0049], [0051]; fig. 3<br>(Family: none) | 1-4 |
| A | WO 2002/016721 A1 (Asahi Glass Co., Ltd.),<br>28 February 2002 (28.02.2002),<br>page 4, line 24 to page 5, line 9<br>(Family: none) | 1-4 |
| A | JP 06-085306 A (Canon Inc.),<br>25 March 1994 (25.03.1994),<br>entire text; all drawings<br>(Family: none) | 1-4 |

☒ Further documents are listed in the continuation of Box C. ☐ See patent family annex.

| * | Special categories of cited documents: | "T" | later document published after the international filing date or priority date and not in conflict with the application but cited to understand the principle or theory underlying the invention |
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search<br>17 June, 2010 (17.06.10) | Date of mailing of the international search report<br>29 June, 2010 (29.06.10) |
| Name and mailing address of the ISA/<br>Japanese Patent Office | Authorized officer |
| Facsimile No. | Telephone No. |

Form PCT/ISA/210 (second sheet) (July 2009)

**INTERNATIONAL SEARCH REPORT**

| International application No. |
| --- |
| PCT/JP2010/059235 |

C (Continuation).    DOCUMENTS CONSIDERED TO BE RELEVANT

| Category* | Citation of document, with indication, where appropriate, of the relevant passages | Relevant to claim No. |
| --- | --- | --- |
| A | JP 09-119202 A  (Kaneka Corp.),<br>06 May 1997 (06.05.1997),<br>paragraph [0023]; fig. 4<br>(Family: none) | 1-4 |

Form PCT/ISA/210 (continuation of second sheet) (July 2009)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 9119202 A

- JP 6085306 A